# EUROPEAN PATENT APPLICATION

(11) **EP 4 746 045 A1**
(43) Date of publication of application: **20.05.2026**
(21) Application number: 24860133.8
(22) Date of filing: 02.07.2024
(51) Int. Cl.: H01L 25/16, H01L 25/075, H10D 86/00, G09G 3/32

(54) **DISPLAY MODULE AND DISPLAY APPARATUS HAVING SAME**

(30) Priority: 01.09.2023 KR 20230116474
(71) Applicant: Samsung Electronics Co., Ltd., Suwon-si, Gyeonggi-do 16677 (KR)
(72) Inventor: PARK, Wonkeun, Suwon-si Gyeonggi-do 16677 (KR); JUNG, Youngki, Suwon-si Gyeonggi-do 16677 (KR); KIM, Donghwan, Suwon-si Gyeonggi-do 16677 (KR); OH, Donggun, Suwon-si Gyeonggi-do 16677 (KR)
(74) Representative: Appleyard Lees IP LLP
(86) International application number: PCT/KR2024/009297
(87) International publication number: WO 2025/048209

(57) **Abstract**

A display module may include: a substrate including a glass substrate and at least one layer staked on the glass substrate; a plurality of light emitting devices arranged on the substrate; a plurality of micro pixel controllers arranged on the substrate and configured to drive the plurality of light emitting devices; a power voltage line arranged below the substrate and configured to receive a power voltage from a power board; and a reference voltage line arranged below the substrate and configured to receive a reference voltage from the power board, wherein the glass substrate may include at least one through glass via (TGV) formed in regions other than regions corresponding to the plurality of light emitting devices and the plurality of micro pixel controllers, the power voltage line may be configured to transmit the power voltage to the plurality of micro pixel controllers arranged on the substrate through the at least one TGV, and the reference voltage line may be configured to transmit the reference voltage to the plurality of micro pixel controllers arranged on the substrate through the at least one TGV.

## Description

### [Technical Field]

The disclosure relates to a display module that implements an image using inorganic light emitting devices, and a display apparatus including the same.

### [Background Art]

Display apparatuses may be divided into self-luminous displays that emit light themselves and light emitting displays that require a separate light source.

A liquid crystal display (LCD) is a representative light emitting display, which is structurally complex and has a limit to implement thinness because the LCD requires a backlight unit for supplying light from behind a display panel, a liquid crystal layer that serves as a switch to pass/block the light, color filters that change the supplied light into desired color, etc.

On the contrary, the self-luminous display having pixels, each of which is equipped with a light emitting device to emit light for itself, dispenses with such elements as the backlight unit, the liquid crystal layer, etc., and may leave out color filters as well, so the self-luminous display has a simple structure and may thus have a high degree of design freedom. Furthermore, the self-luminous display may implement not only thinness, but also a good contrast ratio, brightness, and a viewing angle.

Of the self-luminous displays, a micro light emitting diode (LED) display is one of flat displays, which includes a plurality of micro-sized LEDs. As compared to the LCD that requires backlight, the micro LED display may provide better contrast, response time, and energy efficiency.

Furthermore, the micro LED, which is an inorganic light emitting device, is brighter, has better light emitting efficiency and has a longer lifespan than the organic LED (OLED) that requires an extra encapsulation layer to protect organic materials.

### [Disclosure]

### [Technical Problem]

According to an aspect of the disclosure, the heat generated by supplying voltage for driving a light emitting diode (LED) may be prevented from being concentrated in a specific area of a display module.

According to an aspect of the disclosure, uniform image quality may be provided by minimizing a difference in thermal deterioration between elements of a display module.

Technical aspects that can be achieved by the disclosure are not limited to the above-mentioned aspects, and other technical aspects not mentioned will be clearly understood by one of ordinary skill in the technical art to which the disclosure belongs from the following description.

### [Technical Solution]

According to an aspect of the disclosure, a display module may include: a substrate including a glass substrate and at least one layer staked on the glass substrate; a plurality of light emitting devices arranged on the substrate; a plurality of micro pixel controllers arranged on the substrate and configured to drive the plurality of light emitting devices; a power voltage line arranged below the substrate and configured to receive a power voltage from a power board; and a reference voltage line arranged below the substrate and configured to receive a reference voltage from the power board, wherein the glass substrate may include at least one through glass via (TGV) formed in regions other than regions corresponding to the plurality of light emitting devices and the plurality of micro pixel controllers, the power voltage line may be configured to transmit the power voltage to the plurality of micro pixel controllers arranged on the substrate through the at least one TGV, and the reference voltage line may be configured to transmit the reference voltage to the plurality of micro pixel controllers arranged on the substrate through the at least one TGV.

According to an aspect of the disclosure, a display apparatus may include: a display module including: a substrate including a glass substrate and at least one layer staked on the glass substrate; a plurality of light emitting devices arranged on the substrate; a plurality of micro pixel controllers arranged on the substrate and configured to drive the plurality of light emitting devices; a power voltage line arranged below the substrate and configured to receive a power voltage; and a reference voltage line arranged below the substrate and configured to receive a reference voltage; and a power board configured to supply the power voltage to the power voltage line and supply the reference voltage to the reference voltage line, wherein the glass substrate may include at least one through glass via (TGV) formed in regions other than regions corresponding to the plurality of light emitting devices and the plurality of micro pixel controllers, the power voltage line may be configured to transmit the power voltage to the plurality of micro pixel controllers arranged on the substrate through the at least one TGV, and the reference voltage line may be configured to transmit the reference voltage to the plurality of micro pixel controllers arranged on the substrate through the at least one TGV.

### [Advantageous Effects]

According to the disclosure, the heat generated by supplying voltage for driving a light emitting diode (LED) may be prevented from being concentrated in a specific area of a display module.

According to the disclosure, uniform image quality may be provided by minimizing a difference in thermal deterioration between elements of a display module.

### [Description of Drawings]

FIG. 1 is a perspective view illustrating an example of a display module and a display apparatus including the same according to an embodiment.
FIG. 2 is a diagram illustrating an example of a pixel array constituting a unit module of a display apparatus according to an embodiment.
FIG. 3 and FIG. 4 are control block diagrams of a display apparatus according to an embodiment.
FIG. 5 and FIG. 6 are diagrams illustrating examples of arrangement of micro pixel controllers, in a display module according to an embodiment.
FIG. 7 is a diagram briefly illustrating a basic circuit structure required for a micro pixel controller to supply a driving current to a pixel, in a display module according to an embodiment.
FIG. 8 is a cross-sectional view illustrating a stacked structure of a substrate in a display module according to an embodiment.
FIG. 9 is a plan view illustrating a rear surface of a second buffer layer arranged below a glass substrate in a display module according to an embodiment.
FIG. 10 is a plan view illustrating a rear surface of an insulation layer arranged below a second buffer layer in a display module according to an embodiment.
FIG. 11 is a plan view viewed from above a substrate in a display module according to an embodiment.
FIG. 12 is a plan view viewed from above a substrate in a display module according to an embodiment.
FIG. 13 and FIG. 14 are diagrams illustrating examples of signals transmitted to a plurality of tiled display modules, in a display apparatus according to an embodiment.
FIG. 15 is a diagram illustrating an example of a method in which a plurality of display modules are coupled to a main body, in a display apparatus according to an embodiment.
FIG. 16 is a diagram illustrating an example of black matrix (BM) process performed on a display module according to an embodiment.
FIG. 17 is a diagram illustrating an example of BM process performed on a display apparatus according to an embodiment.

### [Modes of the Invention]

Various embodiments and the terms used therein are not intended to limit the technology disclosed herein to specific forms, and the disclosure should be understood to include various modifications, equivalents, and/or alternatives to the corresponding embodiments.

In describing the drawings, similar reference numerals may be used to designate similar constituent elements.

The singular form of a noun corresponding to an item may include one or more of the items unless clearly indicated otherwise in a related context.

In the disclosure, phrases, such as "A or B", "at least one of A and B", "at least one of A or B", "A, B or C", "at least one of A, B and C", and "at least one of A, B, or C" may include any one or all possible combinations of the items listed together in the corresponding phrase among the phrases.

As used herein, the term "and/or" includes any and all combinations of one or more of the associated listed items.

Terms such as "1st", "2nd", "primary", or "secondary" may be used simply to distinguish an element from other elements, without limiting the element in other aspects (e.g., importance or order).

When an element (e.g., a first element) is referred to as being "(functionally or communicatively) coupled" or "connected" to another element (e.g., a second element), the first element may be connected to the second element, directly (e.g., wired), wirelessly, or through a third element.

It will be understood that when the terms "includes", "comprises", "including", and/or "comprising" are used in the disclosure, they specify the presence of the specified features, figures, steps, operations, components, members, or combinations thereof, but do not preclude the presence or addition of one or more other features, figures, steps, operations, components, members, or combinations thereof.

When a given element is referred to as being "connected to", "coupled to", "supported by" or "in contact with" another element, it is to be understood that it may be directly or indirectly connected to, coupled to, supported by, or in contact with the other element. When a given element is indirectly connected to, coupled to, supported by, or in contact with another element, it is to be understood that it may be connected to, coupled to, supported by, or in contact with the other element through a third element.

It will also be understood that when an element is referred to as being "above" and "below" another element, it may be directly on the other element or intervening elements may also be present.

Further, the terms such as "~portion", "~device", "~block", "~member", "~module", and the like may refer to a unit for processing at least one function or act. For example, the terms may refer to at least one process processed by at least one hardware, such as field-programmable gate array (FPGA)/application specific integrated circuit (ASIC), software stored in memories or processors.

Hereinafter, a display module and a display apparatus including the same according to various embodiments will be described in detail with reference to accompanying drawings.

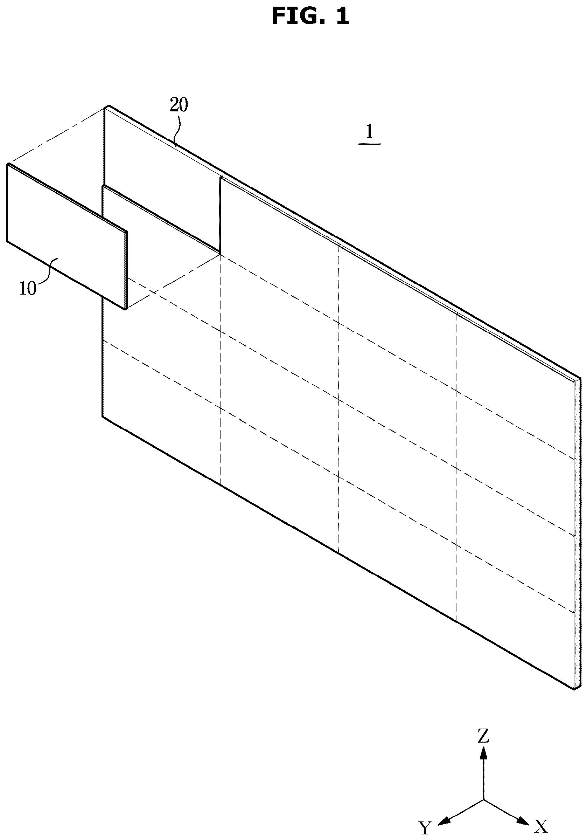

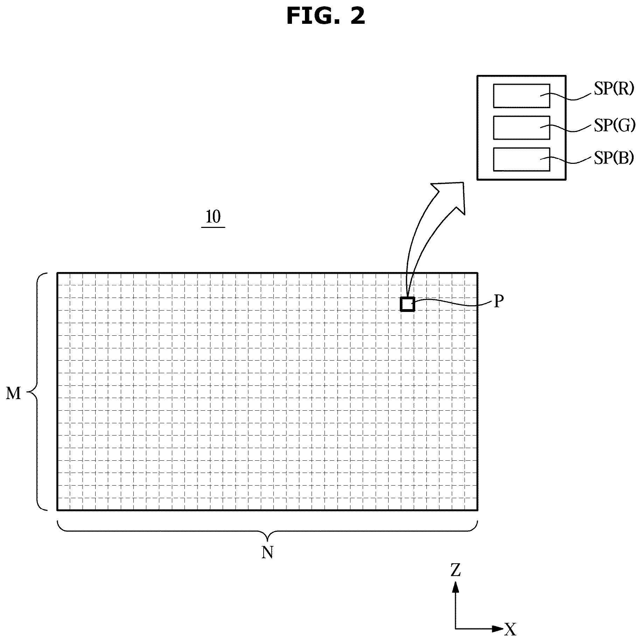

FIG. 1 is a perspective view illustrating an example of a display module and a display apparatus including the same according to an embodiment. FIG. 2 is a diagram illustrating an example of a pixel array constituting a unit module of a display apparatus according to an embodiment.

A display apparatus according to an embodiment is a self-luminous display apparatus having pixels, each of which is equipped with a light emitting device arranged therein to emit light for itself. Accordingly, unlike a liquid crystal display apparatus, the display apparatus dispenses with such components as a backlight unit, a liquid crystal layer, etc., thereby implementing thinness, having a simple structure, and allowing various changes in design.

In addition, the display apparatus according to an embodiment may employ an inorganic light emitting device such as an inorganic light emitting diode (LED) as the light emitting device arranged in each pixel. The inorganic light emitting device has quick response speed as compared with an organic light emitting device such as an organic LED, and may implement high brightness at low electric power.

Furthermore, unlike the organic light emitting device that is vulnerable to exposure to water and oxygen, requires an encapsulation process and has weak durability, the inorganic light emitting device has strong durability without a need for the encapsulation process. Hereinafter, the inorganic light emitting device, as will be described in the following embodiment, refers to the inorganic LED.

The inorganic light emitting device employed in the display apparatus according to an embodiment may be a micro LED, a short side of which has a size of approximately 100 *µ*m, approximately a few tens of *µ*m or a few *µ*m. By employing the micro-sized LEDs, pixel size may be reduced and high resolution may be implemented within the same size screen.

In addition, when an LED chip is manufactured to have a micro size, an inorganic material breaking by nature when bent may be solved. Specifically, when the micro LED chip is transferred onto a flexible substrate, the LED chip does not break, even when the substrate is bent, and thus a flexible display apparatus may be implemented.

The display apparatus employing the micro LED may be applied in various fields by using the subminiature pixel size and great thinness. For example, as shown in FIG. 1, a large-area screen may be implemented by tiling and fixing a plurality of display modules 10, onto which a plurality of micro LEDs are transferred, to a main body 20, and the large-area screen display apparatus may be used as a signage, a billboard, and the like.

Meanwhile, a three-dimensional (3D) coordinate system of XYZ-axes shown in FIG. 1 is based on the display apparatus 1, in which case the screen of the display apparatus 1 is located in the plane XZ and a direction in which the image is output or in which light is emitted from the inorganic light emitting device is direction +Y. As the coordinate system is based on the display apparatus 1, the same coordinate system may be applied to a case when the display apparatus 1 lies on a side and a case when the display apparatus 1 stands up.

The display apparatus 1 is normally used in a standing position and the user watches the image in front of the display apparatus 1. Accordingly, the direction +Y in which the image is output may be referred to as a forward direction and the opposite direction a rearward direction.

In addition, the display apparatus 1 is normally manufactured in a lying position. Accordingly, the direction -Y of the display apparatus 1 may be referred to as a downward direction and the direction +Y may be referred to as an upward direction. In the following embodiments, the direction +Y may be referred to as the upward direction or the forward direction and the direction -Y may be referred to as the downward direction or the rearward direction.

Four surfaces other than the upper and lower surfaces of the display apparatus 1 or the display module 10 of a flat form will be herein referred to as side surfaces, regardless of the posture of the display apparatus 1 or the display module 10.

Although the display apparatus 1 is shown as including a plurality of display modules to implement a large-area screen in the example of FIG. 1, embodiments of the display apparatus 1 are not limited thereto. The display apparatus 1 may include a single display module 10 and may be implemented as a television, a wearable device, a portable device, a personal computer (PC) monitor, etc.

Referring to FIG. 2, the display module 10 may include M x N (M and N are integers equal to or greater than 2) pixels, i.e., a plurality of pixels arranged in two dimensions (2D). Conceptual pixel arrangement is illustrated in FIG. 2, and it is obvious that there may be a bezel area or a wiring area in which no image is displayed may be arranged in the display module 10 in addition to an active area in which the pixels are arranged.

In the embodiment, some components being arranged in 2D may include not only the case where the components are arranged in the same plane but also the case where the components are arranged in different parallel planes. Additionally, in the case where the components are arranged in the same plane, tops of the components do not need to be leveled in the same plane but may also be in different parallel planes.

A pixel P may include a plurality of sub-pixels which output light of different colors to implement various colors by color combinations. For example, a pixel P may include at least three sub-pixels which output different colors of light. Specifically, a pixel P may include three sub-pixels SP (R), SP (G), and SP (B) corresponding to red (R), green (G), and blue (B), respectively. The red sub-pixel SP (R) may output red light, the green sub-pixel SP (G) may output green light, and the blue sub-pixel SP (B) may output blue light.

However, the pixel arrangement is merely an example to be applied to the display module 10 and the display apparatus 1 according to an embodiment, and the sub-pixels may also be arranged along the X-axis, not be arranged in one line, or be implemented in different sizes. A single pixel simply requires to include a plurality of sub-pixels to implement multiple colors, and there are no limitations on the size or arrangement scheme of the sub-pixels.

In addition, the pixel P does not need to include the red sub-pixel SP (R) that outputs red light, the green sub-pixel SP (G) that outputs green light, and the blue sub-pixel SP (B) that outputs blue light, but may include a sub-pixel that outputs yellow light or white light. That is, the color of light output from each sub-pixel, the sub-pixel type, or the number of the sub-pixels are not limited.

In the following embodiments, for specific description, a case where the pixel P includes the red sub-pixel SP (R), the green sub-pixel SR (G) and the blue sub-pixel SP (B) will be taken as an example.

As described above, the display module 10 and the display apparatus 1 according to an embodiment is the self-luminous display apparatus having pixels, each of which is capable of emitting light for itself. Accordingly, sub-pixels may include inorganic light emitting devices that emit different colors of light. For example, a red inorganic light emitting device may be arranged in the red sub-pixel SP (R), a green inorganic light emitting device may be arranged in the green sub-pixel SP (G), and a blue inorganic light emitting device may be arranged in the blue sub-pixel SP (B).

Accordingly, in the embodiment, the pixel P may refer to a cluster including a red inorganic light emitting device, a green inorganic light emitting device, and a blue inorganic light emitting device, and the sub-pixel may refer to each inorganic light emitting device.

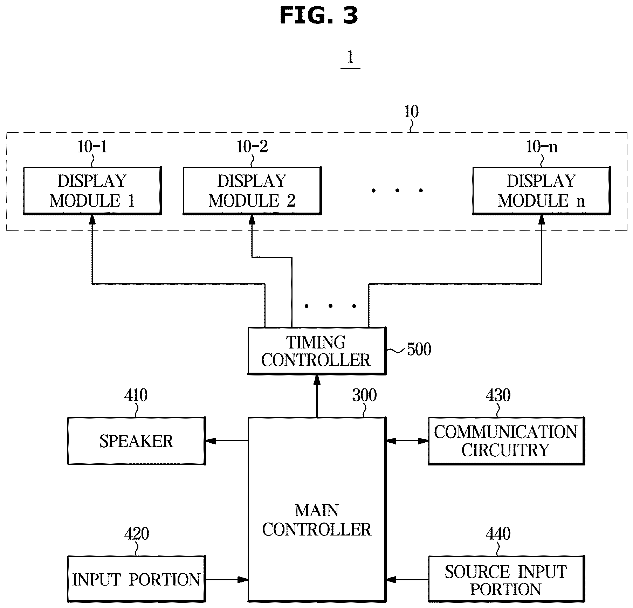

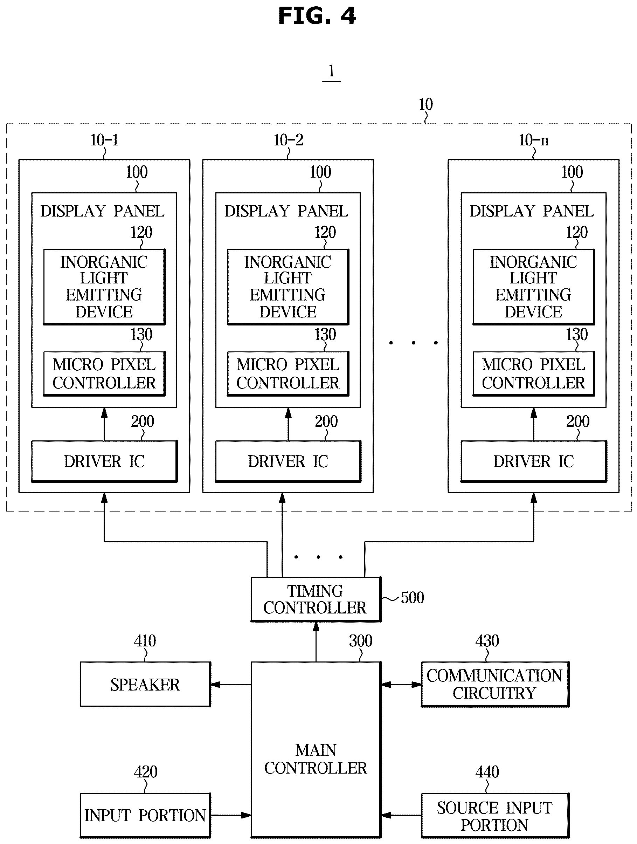

FIG. 3 and FIG. 4 are control block diagrams of the display apparatus according to an embodiment.

Referring to FIG. 3, the display apparatus 1 may include a plurality of display modules 10-1, 10-2, ..., 10-n, where n is an integer equal to or greater than 2, a main controller 300 and a timing controller 500 for controlling the plurality of display modules 10, communication circuitry 430 for communicating with an external device, a source input portion 440 for receiving a source image, a speaker 410 for outputting sound, and an input portion 420 for receiving a command to control the display apparatus 1 from a user.

The input portion 420 may include a button or a touch pad arranged in a region of the display apparatus 1, or the input portion 420 may include a touch pad arranged on the front surface of a display panel 100 (see FIG. 4) in a case where the display panel 100 is implemented as a touch screen.

The input portion 420 may receive, from the user, various commands to control the display apparatus 1, such as power on/off, volume control, channel tuning, screen adjustment, various settings change, and the like.

The speaker 410 may be arranged in a portion of the main body 20, or an extra speaker module physically separated from the main body 20 may be further provided.

The communication circuitry 430 may communicate with a relay server or another electronic device to exchange data required. The communication circuitry 430 may employ at least one of various radio communication methods, such as third generation (3G), fourth generation (4G), wireless local area network (WLAN), wireless fidelity (Wi-Fi), Bluetooth, Zigbee, Wi-Fi direct (WFD), ultra-wideband (UWB), infrared data association (IrDA), Bluetooth low energy (BLE), near field communication (NFC), Z-wave, etc. In addition, a wired communication method, such as peripheral component interconnect (PCI), PCI-express, universal serial bus, and the like, may be employed.

The source input portion 440 may receive a source signal input from a set top box, a universal serial bus (USB), an antenna, etc. Accordingly, the source input portion 440 may include at least one selected from a source input interface group including a high-definition multimedia interface (HDMI) cable port, a USB port, an antenna, etc.

The source signal received by the source input portion 440 may be processed by the main controller 300 and converted into a format that may be output from the display panel 100 and the speaker 410.

The main controller 300 and the timing controller 500 may include at least one memory storing a program and various types of data to perform operations, which will be described later, and at least one processor executing the stored program.

The main controller 300 may process the source signal input through the source input portion 440 to generate an image signal corresponding to the input source signal.

For example, the main controller 300 may include a source decoder, a scaler, an image enhancer and a graphic processor. The source decoder may decode a source signal compressed in such a format as MPEG, and the scaler may output image data of a desired resolution through resolution conversion.

The image enhancer may enhance image quality of the image data by applying various correction techniques. The graphic processor may sort the image data into RGB data, and output the RGB data along with a control signal such as a syncing signal for display timing on the display panel 100. In other words, the main controller 300 may output image data corresponding to a source signal with a control signal.

The aforementioned operations of the main controller 300 are merely an example that is applicable to the display apparatus 1, and an additional operation may be further performed, or some of the aforementioned operations may be omitted.

The image data and control signal output from the main controller 300 may be transmitted to the timing controller 500.

The timing controller 500 may convert the image data transmitted from the main controller 300 into a format that may be processed in a driver integrated circuit (IC) 200 (see FIG. 4), and may generate various control signals such as a timing control signal required to display the image data on the display panel 100.

The display apparatus 1 does not need to include the plurality of display modules 10, but in the following embodiments, the display apparatus 1 including the plurality of display modules 10 will be taken as an example for specific description and operation of each of the components will be described in detail.

Referring to FIG. 4, each of the plurality of display modules 10-1, 10-2, ..., 10-n may include the display panel 100 that displays an image and the driver IC 200 that drives the display panel 100.

The display panel 100 may include a plurality of pixels arranged two-dimensionally as described above, and each pixel may include a plurality of sub-pixels to implement various colors.

In addition, as described above, the display apparatus 1 according to an embodiment is a self-emissive display apparatus in which each pixel may emit light by itself. Accordingly, an inorganic light emitting device 120 may be arranged in each sub-pixel. That is, each of the plurality of pixels may include two or more inorganic light emitting devices 120.

Each inorganic light emitting device 120 may be driven by an active matrix (AM) method or a passive matrix (PM) method, but in the following embodiments, the case where the inorganic light emitting device 120 is driven by the AM method will be described as an example for specific description.

In the display module 10 according to an embodiment, each inorganic light emitting device 120 may be individually controlled by a micro pixel controller 130, and the micro pixel controller 130 may operate based on a driving signal output from the driver IC 200 or a timing control signal output from the timing controller 500.

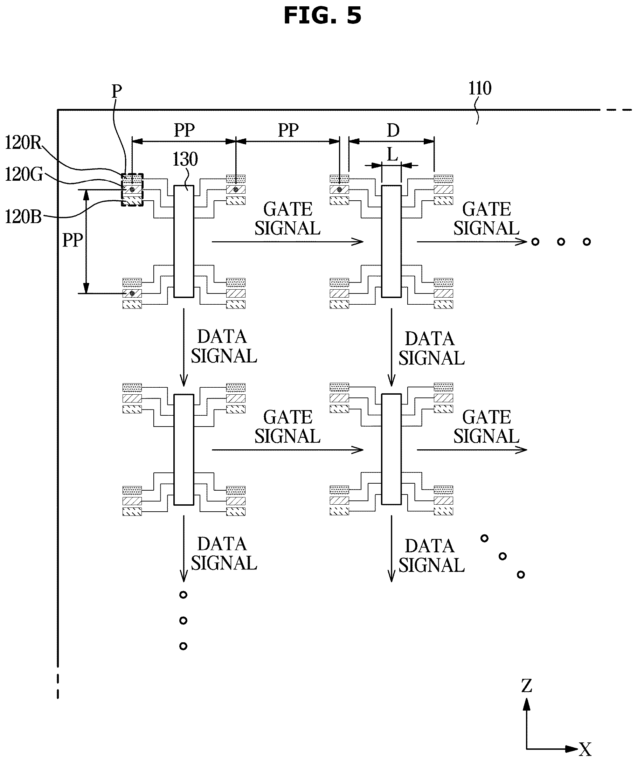

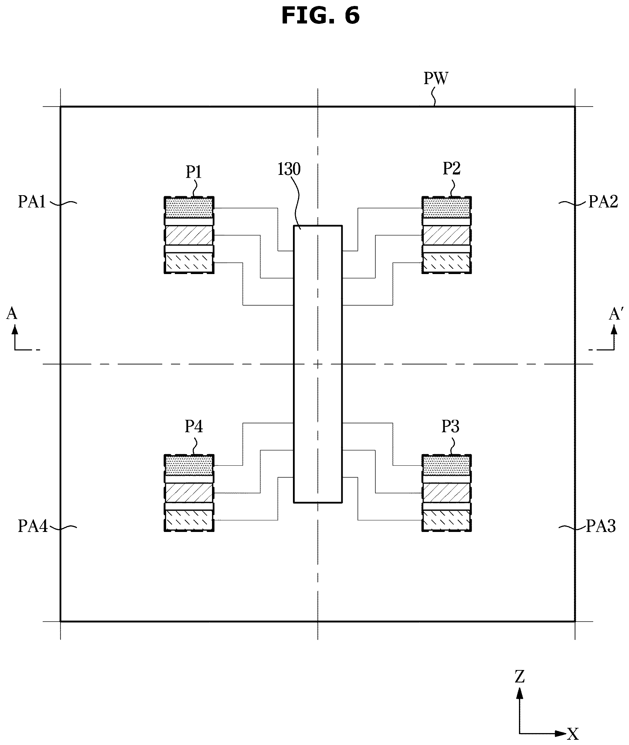

FIG. 5 and FIG. 6 are diagrams illustrating examples of arrangement of the micro pixel controllers, in the display module according to an embodiment.

Referring to FIG. 5, a plurality of pixels P may be arranged two-dimensionally on the substrate 110, and the micro pixel controllers 130 may be arranged in regions on the substrate 110 where no pixels P are arranged.

In arranging the plurality of pixels P on the substrate 110, the pixel intervals PP between adjacent pixels located above, below, on the left, and on the right may all be maintained to be the same. In the embodiment, "being the same" may include not only the case where the values are completely identical, but also the case where the values match within a predefined error range.

The pixel interval PP may be referred to as pixel pitch, and in the embodiment, the pixel interval PP is defined to represent a distance from a center of one pixel to a center of an adjacent pixel. However, embodiments of the display module 10 are not limited thereto, and the pixel interval PP may be defined otherwise.

One micro pixel controller 130 may control two or more pixels P, and the micro pixel controller 130 may be arranged in the space between two or more pixels P. In the example of FIG. 5, a case where one micro pixel controller 130 controls four pixels P is shown, but embodiments of the display module 10 are not limited thereto, and the number of pixels P controlled by the micro pixel controller 130 are not limited.

For example, in a case where the micro pixel controller 130 has a rectangular parallelepiped shape, the length L of the short side of the upper surface or the lower surface of the micro pixel controller 130 may be provided in a micro size shorter than the distance D between the boundaries of the adjacent pixels P, and the short side of the micro pixel controller 130 may be arranged parallel to a vertical line representing the shortest distance between two adjacent pixels P. Here, the distance D between the boundaries of the adjacent pixels P may refer to a distance between adjacent inorganic light emitting devices 120 that belong to different pixels P.

That is, the micro pixel controllers 130 may be arranged without affecting the intervals between the plurality of pixels P. Accordingly, even in a case where the micro pixel controllers 130 are arranged between the pixels P, the pixel interval may be minimized, thereby achieving high resolution within the same region.

Meanwhile, in a case where a single micro pixel controller 130 controls pixels P in an m x 2 array (where m is an integer greater than or equal to 1), the micro pixel controller 130 may be arranged between two columns where the controlled pixels P (hereinafter also referred to as 'target control pixels') are arranged, as shown in FIG. 6.

Alternatively, in a case where a single micro pixel controller 130 controls pixels P in a 2 x n array (where n is an integer greater than or equal to 1), the micro pixel controller 130 may be arranged between two rows where the controlled pixels P are arranged.

FIG. 6 is an enlarged view illustrating the arrangement of a micro pixel controller that controls a 2x2 array of pixels and its target control pixels.

Referring to FIG. 6, the micro pixel controller 130 may be arranged in at least one of the pixel regions PA1, PA2, PA3, and PA4 of the four pixels P1, P2, P3, and P4, respectively, that are controlled by the micro pixel controller 130. In the embodiment, a pixel region may be a region where each pixel is located, and when the active area of the display panel 100 is divided into an array (M x N), identical to the pixel array, an area containing each pixel may be defined as the pixel region of that pixel.

Specifically, the micro pixel controller 130 may be arranged in one of the pixel regions PA1, PA2, PA3, and PA4 of the pixels controlled by the micro pixel controller 130, or may be arranged across two of these regions, or across three regions, or across four regions, as shown in FIG. 6.

Alternatively, the micro pixel controller 130 may be arranged at the center of a single region, i.e., the entire pixel region PW, which is the sum of the pixel regions PA1, PA2, PA3, and PA4 of the four pixels P1, P2, P3, and P4 controlled by the micro pixel controller 130.

In a case where the micro pixel controller 130 is arranged as described above, driving current may be efficiently supplied to the plurality of pixels P controlled by the micro pixel controller 130. The configuration for supplying driving current to the target control pixels P will be described in detail below.

Meanwhile, the micro pixel controller 130 may be electrically connected to the target control pixels to control the plurality of pixels P. In the embodiment, two components being electrically connected may include not only connection through wiring, but also direct soldering of electrically conductive materials or the use of conductive adhesives. A connection method is not limited, as long as current flows between the two connected components.

For example, when soldering two components, Au-In bonding, Au-Sn bonding, Cu pillar/SnAg bump bonding, Ni pillar/SnAg bump bonding, SnAgCu, SnBi, SnAg solder ball bonding, or the like may be used.

When a conductive adhesive is used, a conductive adhesive, such as an anisotropic conductive film (ACF) or an anisotropic conductive paste (ACP), may be arranged between the two components, and pressure is applied thereto so that current may flow in the direction in which the pressure is applied.

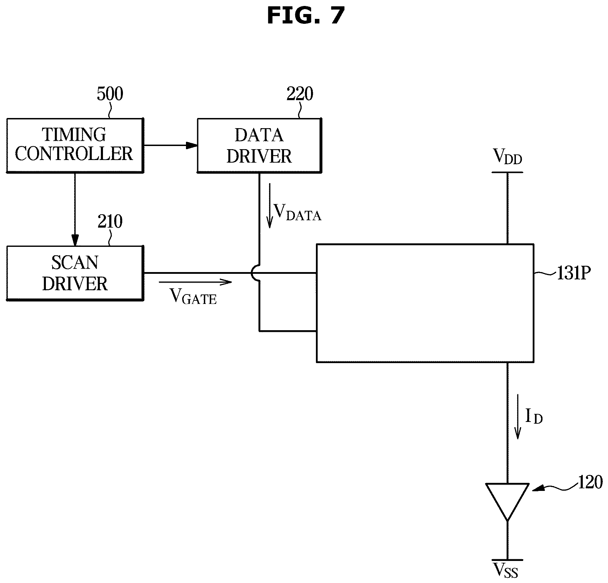

FIG. 7 is a diagram briefly illustrating a basic circuit structure required for a micro pixel controller to supply a driving current to a pixel, in the display module according to an embodiment.

Referring to FIG. 7, the driver IC 200 may include a scan driver 210 and a data driver 220. The scan driver 210 may output a gate signal for turning on/off a sub-pixel, and the data driver 220 may output a data signal for implementing an image.

The scan driver 210 may generate a gate signal based on a timing control signal transmitted from the timing controller 500, and the data driver 220 may generate a data signal based on image data transmitted from the timing controller 500. The gate signal may include a gate voltage V_{GATE} for turning on a sub-pixel, and the data signal may include a data voltage V_{DATA} representing a grayscale of an image.

The scan driver 210 may be formed on the substrate 110 in a gate in panel (GIP) manner according to various designs, and may output the gate signal.

The micro pixel controller 130 may include a pixel circuit 131P for individually controlling each inorganic light emitting device 120, and the gate signal output from the scan driver 210 and the data signal output from the data driver 220 may be input to the pixel circuit 131P.

For example, when the gate voltage V_{GATE}, the data voltage V_{DATA}, and a power voltage are input to the pixel circuit 131P, the pixel circuit 131P may output a driving current I_{D} for driving the inorganic light emitting device 120.

The driving current I_{D} output from the pixel circuit 131P may be input to the inorganic light emitting device 120, and the inorganic light emitting device 120 may emit light by the input driving current I_{D} to implement an image.

A constant voltage includes a power voltage and a reference voltage. The power voltage is a voltage supplied to the pixel circuit 131P, and when the power voltage is supplied to the pixel circuit 131P as described above, the pixel circuit 131P may output the driving current I_{D}. The reference voltage may be applied to a cathode 125b of the inorganic light emitting device 120.

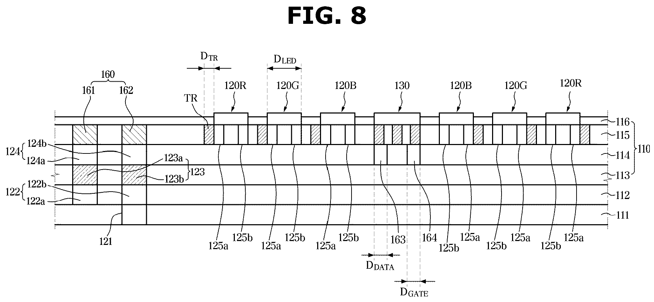

FIG. 8 is a cross-sectional view illustrating a stacked structure of a substrate in the display module according to an embodiment.

Referring to FIG. 8, the substrate 110 may include a glass substrate 113, a first buffer layer 114, a thin film transistor (TFT) layer 115, and a planarization layer 116. The upper side of the glass substrate 113 may indicate the +Y direction, and the lower side of the glass substrate 113 may indicate the - Y direction.

The glass substrate 113 may include a through glass via (TGV) 123. The TGV 123 may be formed by a via filling process that includes plating the inner wall of a hole penetrating the glass substrate 113, formed through various etching technologies, such as etching using an etchant (e.g., hydrofluoric acid) or laser etching (e.g., laser induced etching (LIE), laser induced deep etching (LIDE)), with a conductive material (e.g., copper), and then filling the hole with a via filling material.

The TGV 123 may transmit an electrical signal received from the lower side of the glass substrate 113 to a substrate via hole 124 provided on the upper side of the glass substrate 113.

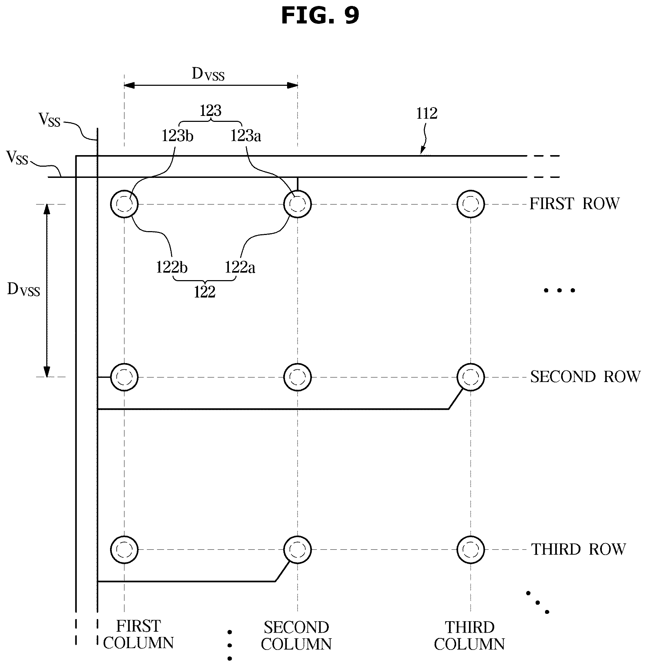

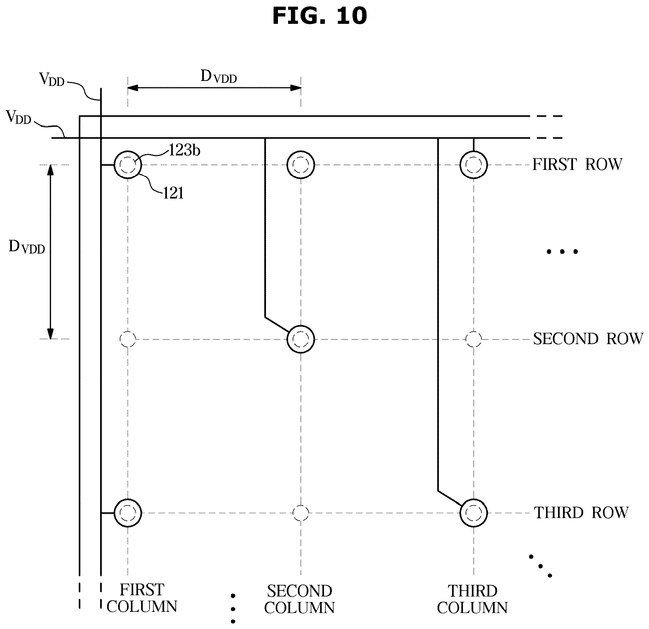

Specifically, the TGV 123 may include a reference voltage TGV 123a and a power voltage TGV 123b. The reference voltage TGV 123a may transmit a reference voltage, received from a reference voltage line V_{SS} (see FIG. 9) provided on the lower side of the glass substrate 113, to a substrate reference voltage via hole 124a provided on the upper side of the glass substrate 113. The power voltage TGV 123b may transmit a power voltage, received from a power voltage line V_{DD} (see FIG. 10) provided on the lower side of the glass substrate 113, to a substrate power voltage via hole 124b provided on the upper side of the glass substrate 113.

The first buffer layer 114 may be formed on the glass substrate 113, and the TFT layer 115 may be formed on the first buffer layer 114.

The first buffer layer 114 may provide a planar surface on the upper side of the glass substrate 113, and may block foreign substances or moisture from penetrating through the glass substrate 113. For example, the first buffer layer 114 may contain inorganic materials, such as silicon oxide, silicon nitride, silicon oxynitride, aluminum oxide, aluminum nitride, titanium oxide, or titanium nitride, or organic materials, such as polyimide, polyester, or acrylic, and may also be formed as a plurality of stacked layers of the exemplified materials.

The first buffer layer 114 may include the substrate via hole 124. The substrate via hole 124 may transmit an electrical signal, received from the lower side of the first buffer layer 114, to a constant voltage electrode 160 provided on the upper side of the first buffer layer 114.

Specifically, the substrate via hole 124 may include the substrate reference voltage via hole 124a and the substrate power voltage via hole 124b. The substrate reference voltage via hole 124a may transmit a reference voltage, received from the reference voltage TGV 123a, to the constant voltage electrode 160, and the substrate power voltage via hole 124b may transmit a power voltage, received from the power voltage TGV 123b, to the constant voltage electrode 160.

The first buffer layer 114 may include a data line 163 and a gate line 164. The data line 163 may transmit a data signal, received from the data driver 220, to the micro pixel controller 130. The gate line 164 may transmit a gate signal, received from the scan driver 210, to the micro pixel controller 130.

The TGV 123 may be formed in regions other than the data line region D_{DATA} and the gate line region D_{GATE}. The region other than the data line region D_{DATA} refers to a region that does not overlap with the region in which the data line 163 is formed in the vertical direction (+Y to -Y direction) of the substrate 110. The region other than the gate line region D_{GATE} refers to a region that does not overlap with the region in which the gate line 164 is formed in the vertical direction (+Y to -Y direction) of the substrate 110.

The TFT layer 115 may include the constant voltage electrode 160. The constant voltage electrode 160 may transmit a constant voltage (reference voltage, power voltage) to the micro pixel controller 130.

The constant voltage electrode 160 may include the reference voltage electrode 161 and the power voltage electrode 162. The reference voltage electrode 161 may transmit a reference voltage to the micro pixel controller 130, and the power voltage electrode 162 may transmit a power voltage to the micro pixel controller 130.

The constant voltage electrode 160 may transmit the constant voltage received from the substrate via hole 124 to the micro pixel controller 130.

Specifically, the reference voltage electrode 161 may transmit the reference voltage, received from the substrate reference voltage via hole 124a, to the micro pixel controller 130, and the power voltage electrode 162 may transmit the power voltage, received from the substrate power voltage via hole 124b, to the micro pixel controller 130.

The TFT layer 115 may include a thin film transistor TR. The thin film transistor TR may receive a data signal from the data line 163 or a gate signal from the gate line 164.

The thin film transistor TR may receive the power voltage from the power voltage electrode 162 and supply a driving current I_{D} to the inorganic light emitting device 120.

Specifically, the thin film transistor TR may be electrically connected to an anode 125a of the inorganic light emitting device 120 to supply the driving current ID.

The thin film transistor TR is a component of the pixel circuit 131P and may supply the driving current I_{D} to the inorganic light emitting device 120.

The TGV 123 may be formed in a region other than a thin film transistor region D_{TR}. The region other than the thin film transistor region D_{TR} refers to a region that does not overlap with the region in which the thin film transistor TR is formed in the vertical direction (+Y to -Y direction) of the substrate 110.

The inorganic light emitting devices 120 may be arranged on the first buffer layer 114. The inorganic light emitting device 120 may include the anode 125a and the cathode 125b. The anode 125a may receive a driving current I_{D} from the thin film transistor TR. The cathode 125b may receive a reference voltage from the reference voltage electrode 161.

The TGV 123 may be formed in a region other than an inorganic light emitting device region D_{LED}. The region other than the inorganic light emitting device region D_{LED} refers to a region that does not overlap with the region in which the inorganic light emitting device 120 is formed in the vertical direction (+Y to -Y direction) of the substrate 110.

The micro pixel controller 130 may be arranged above the first buffer layer 114. The micro pixel controller 130 may be electrically connected to the data line 163. Specifically, the micro pixel controller 130 may receive a data signal from the data line 163.

The micro pixel controller 130 may be electrically connected to the gate line 164. Specifically, the micro pixel controller 130 may receive a gate signal from the gate line 164.

The micro pixel controller 130 may include the pixel circuit 131P. The pixel circuit 131P may receive a constant voltage (reference voltage and power voltage) from the constant voltage electrode 160 to drive the inorganic light emitting device 120.

In addition to the pixel circuit 131P, the micro pixel controller 130 may include various elements (e.g., a pulse width modulation (PWM) controller, a pulse amplitude modulation (PAM) controller, a slope waveform controller, etc.) that control signals for driving the inorganic light emitting device 120.

The TGV 123 may be formed in a region other than the micro pixel controller region. The region other than the micro pixel controller region refers to a region that does not overlap with the region in which various elements included in the micro pixel controller 130 and the wiring for connecting the elements are present in the vertical direction (+Y to -Y direction) of the substrate 110.

The planarization layer 116 may be formed on the TFT layer 115. The inorganic light emitting device 120 or the micro pixel controller 130 may be arranged on the planarization layer 116.

The second buffer layer 112 may be formed below the glass substrate 113. The second buffer layer 112 may include a first via hole 122.

The first via hole 122 may be electrically connected to the constant voltage power lines (V_{SS}, V_{DD}). Specifically, the first reference voltage via hole 122a may receive a reference voltage from the reference voltage line V_{SS}, and the first power voltage via hole 122b may receive a power voltage from the power voltage line V_{DD}.

The first via hole 122 may be electrically connected to the TGV 123. Specifically, the first reference voltage via hole 122a may transmit the reference voltage, received from the reference voltage line V_{SS}, to the reference voltage TGV 123a, and the first power voltage via hole 122b may transmit the power voltage, received from the power voltage line V_{DD}, to the power voltage TGV 123b.

The second buffer layer 112 may provide a planar surface on the lower side of the glass substrate 113, and may block foreign substances or moisture from penetrating through the glass substrate 113. For example, the second buffer layer 112 may contain inorganic materials, such as silicon oxide, silicon nitride, silicon oxynitride, aluminum oxide, aluminum nitride, titanium oxide, or titanium nitride, or organic materials, such as polyimide, polyester, or acrylic, and may also be formed as a plurality of stacked layers of the exemplified materials.

An insulation layer 111 may be formed below the second buffer layer 112. The insulation layer 111 may include a second via hole 121. The second via hole 121 may be electrically connected to the power voltage line V_{DD}.

Specifically, the second via hole 121 may transmit the power voltage, received from the power voltage line V_{DD}, to the first power voltage via hole 122b.

FIG. 9 is a plan view illustrating a rear surface of the second buffer layer arranged below the glass substrate in the display module according to an embodiment. FIG. 10 is a plan view illustrating a rear surface of the insulation layer arranged below the second buffer layer in the display module according to an embodiment.

Referring to FIG. 9, the second buffer layer 112 includes the first via hole 122 that is electrically connected to the TGV 123. The first via hole 122 may be formed below the region where the TGV 123 is formed in the glass substrate 113 and may be electrically connected to the TGV 123.

Specifically, the first reference voltage via hole 122a may be connected to the reference voltage line V_{SS} and may transmit the reference voltage received from the reference voltage line V_{SS} to the reference voltage TGV 123a.

Accordingly, the reference voltage, supplied to the reference voltage line V_{SS} provided on the lower side of the glass substrate 113, may be transmitted to the micro pixel controller 130 provided on the upper side of the glass substrate 113 through the reference voltage TGV 123a.

The first via holes 122 may be arranged in the same column and/or the same row on the second buffer layer 112. For example, a plurality of first via holes 122 may be arranged in an m x n array (where m and n are positive integers, and at least one of m and n is 2 or more) in the second buffer layer 112.

The first via holes 122 may be arranged at equal intervals. For example, the interval D_{VSS} between the first via holes 122 arranged along the first column may be the same. As another example, the interval D_{VSS} between the first via holes 122 arranged along the first row may be the same.

In the embodiment, "being the same" may include not only the case where the values are completely identical, but also the case where the values match within a predefined error range.

Referring to FIG. 10, the insulation layer 111 includes the second via hole 121 that is electrically connected to the first via hole 122. The second via hole 121 may be formed below the region where the first via hole 122 is formed in the second buffer layer 112 and may be electrically connected to the first via hole 122.

Specifically, the second via hole 121 may be connected to the power voltage line V_{DD}, and may transmit the power voltage received from the power voltage line V_{DD} to the first power voltage via hole 122b. The first power voltage via hole 122b may transmit the power voltage received from the second via hole 121 to the power voltage TGV 123b.

Accordingly, the power voltage, supplied to the power voltage line V_{DD} provided on the lower side of the glass substrate 113, may be transmitted to the micro pixel controller 130 provided on the upper side of the glass substrate 113 through the power voltage TGV 123b.

The second via holes 121 may be arranged in the same column and/or the same row on the insulation layer 111. For example, a plurality of second via holes 121 may be arranged in an m x n array (where m and n are positive integers, and at least one of m and n is 2 or more) in the insulation layer 111.

The second via holes 121 may be arranged at equal intervals. For example, the interval D_{VDD} between the second via holes 121 arranged along the first column may be the same. As another example, the interval D_{VDD} between the second via holes 121 arranged along the first row may be the same.

In the embodiment, "being the same" may include not only the case where the values are completely identical, but also the case where the values match within a predefined error range.

However, depending on various designs, the reference voltage line V_{SS} and the power voltage line V_{DD} may be provided in the display module 10 differently from the embodiments described in FIG. 9 and FIG. 10. For example, the first via hole 122 may be electrically connected to the power voltage line V_{DD} to transmit the power voltage to the TGV 123, and the second via hole 121 may be electrically connected to the reference voltage line V_{SS} to transmit the reference voltage to the TGV 123.

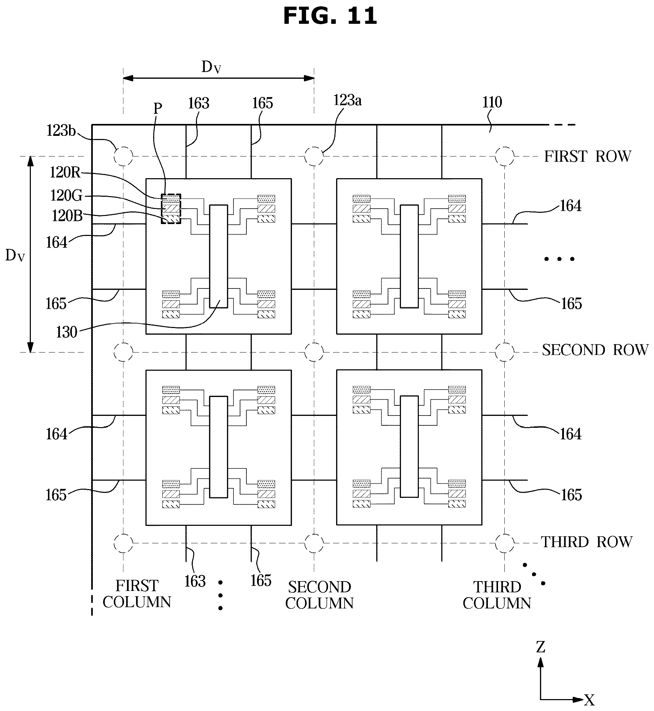

FIG. 11 is a plan view viewed from above a substrate in a display module according to an embodiment.

Referring to FIG. 11, the micro pixel controller 130 may receive electrical signals from the data line 163, the gate line 164, and a line 165 that connects various elements (e.g., a PWM controller, a PAM controller, a slope waveform controller, etc.) within the micro pixel controller 130.

The TGV 123 may be formed in a region other than a line region. The line region refers to a region that does not overlap with the regions occupied by the data line 163, the gate line 164, and the line 165 connecting various elements within the micro pixel controller 130 in the vertical direction (+Y to -Y direction) of the substrate 110.

The TGV 123 may be formed in a region other than the entire pixel region PW. The region other than the entire pixel region PW refers to a region that does not overlap with the regions occupied by the micro pixel controller 130, the inorganic light emitting device 120, and the thin film transistor TR in the vertical direction (+Y to -Y direction) of the substrate 110.

The TGVs 123 may be arranged in the same column and/or the same row on the substrate 110. For example, a plurality of TGVs 123 may be arranged in an m x n array (where m and n are positive integers, and at least one of m and n is 2 or more) on the substrate 110.

The TGVs 123 may be arranged at equal intervals. For example, the interval Dv between the TGVs 123 arranged along the first column may be the same. As another example, the interval Dv between the TGVs 123 arranged along the first row may be the same.

Referring to FIG. 9 to FIG. 11, the second via hole 121, the first via hole 122, and the TGV 123 may be arranged in the same region in the vertical direction (+Y to -Y direction) of the substrate 110, and the interval D_{VSS} between adjacent first via holes 122, the interval D_{VDD} between adjacent second via holes 121, and the interval Dv between adjacent TGVs 123 may be the same.

The reference voltage values transmitted through each first reference voltage via hole 122a and each reference voltage TGV 123a may be the same. The power voltage values transmitted through each second via hole 121, each first power voltage via hole 122b, and each power voltage TGV 123b may be the same.

In the embodiment, "being the same" may include not only the case where the values are completely identical, but also the case where the values match within a predefined error range.

When voltage is transmitted through wiring or via holes, heat may be generated. The generated heat may be continuously transmitted to elements (e.g., inorganic light emitting device 120, thin film transistor TR, etc.) within the display module 10, causing thermal deterioration. Thermal deterioration refers to a phenomenon in which the performance of a device deteriorates due to heat, light, or the like.

In a case where a constant voltage (reference voltage and power voltage) is not uniformly transmitted within the display module 10, a difference in thermal deterioration between elements within the display module 10 may occur.

According to embodiments of the disclosure, by transmitting a uniform voltage to each element in the display module 10, a difference in thermal deterioration caused by heat being concentrated in a specific area of each element may be minimized.

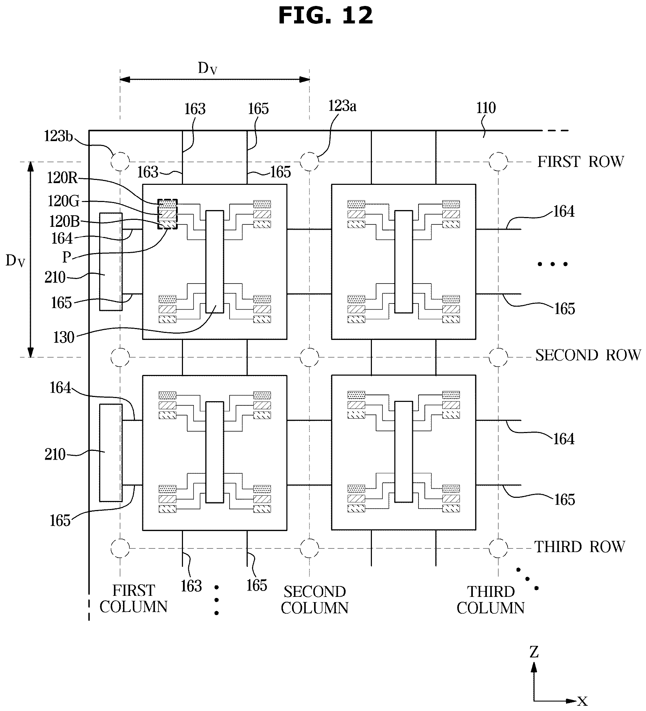

FIG. 12 is a plan view viewed from above a substrate in a display module according to an embodiment.

Referring to FIG. 12, the scan driver 210 may be provided on the substrate 110 in a gate in panel (GIP) manner. GIP refers to a technology that may reduce the complexity of the wiring structure of the display apparatus 1 by arranging the scan driver 210 in a region other than the line region.

The scan driver 210 may include a GIP circuit, and the GIP circuit may transmit a gate signal to the micro pixel controller 130 through the GIP line 164.

The TGV 123 may be formed in a region other than the scan driver 210 and the GIP line 164 provided on the substrate 110 in the GIP manner. The region other than the scan driver 210 and the GIP line 164 provided on the substrate 110 in the GIP manner refers to a region that does not overlap with the regions occupied by the scan driver 210 and the GIP line 164, provided on the substrate 110 in the GIP manner, in the vertical direction (+Y to -Y direction) of the substrate 110.

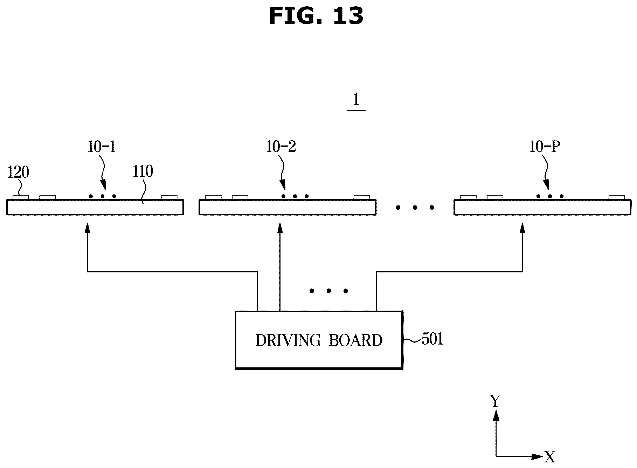

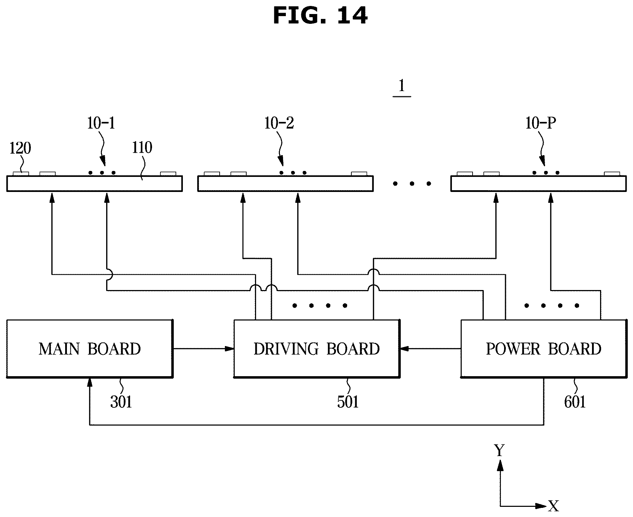

FIG. 13 and FIG. 14 are diagrams illustrating examples of signals transmitted to a plurality of tiled display modules in a display apparatus according to an embodiment.

As described above, a plurality of display modules 10-1, 10-2, ..., 10-n may be tiled to implement a display apparatus 1 having a large-area screen. As FIG. 13 and FIG. 14 illustrate the display apparatus 1 on the XY plane, although the display modules 10-1, 10-2, ..., 10-n just appear in one dimensional array, it is obvious that the plurality of display modules 10-1, 10-2, ..., and 10-n may be arranged in 2D as described above with reference to FIG. 1.

The display panel 100 may be connected to a flexible printed circuit board (FPCB) through a film on which the driver IC 200 is mounted. The FPCB may be connected to a driving board 501 to electrically connect the display module 10 to the driving board 501.

The timing controller 500 may be arranged on the driving board 501. Accordingly, the driving board 501 may also be referred to as a T-con board. The plurality of display modules 10-1, 10-2, ..., 10-n may receive image data, timing control signals, and the like, from the driving board 501.

Referring to FIG. 14, the display apparatus 1 may further include a main board 301 and a power board 601. The main board 301 may be provided with the main controller 300 described above, and the power board 601 may be provided with a power circuit required to supply power to the plurality of display modules 10-1, 10-2, ..., 10-n.

The power board 601 may be electrically connected to the plurality of display modules 10-1, 10-2, ..., 10-n through an FPCB, and may apply power voltage, reference voltage, and the like, to the plurality of display modules 10-1, 10-2, ..., 10-n connected through the FPCB.

For example, the power voltage supplied from the power board 601 may be applied to the micro controller 130 through the power voltage line V_{DD}, the second via hole 121, the first power voltage via hole 122b, the power voltage TGV 123b, the substrate power voltage via hole 124b, and the power voltage electrode 162. The reference voltage supplied from the power board 601 may be applied to the micro pixel controller 130 or the inorganic light emitting device 120 through the power voltage line V_{DD}, the first reference voltage via hole 122a, the reference voltage TGV 123a, the substrate reference voltage via hole 124a, and the reference voltage electrode 161.

In the foregoing example, although it has been described that the plurality of display modules 10-1, 10-2, ..., 10-n share the driving board 501, a separate driving board 501 may be connected to each individual display module 10. Alternatively, the plurality of display modules 10-1, 10-2, ..., 10-n and may be grouped and a group of display modules may be connected to one driving board 501.

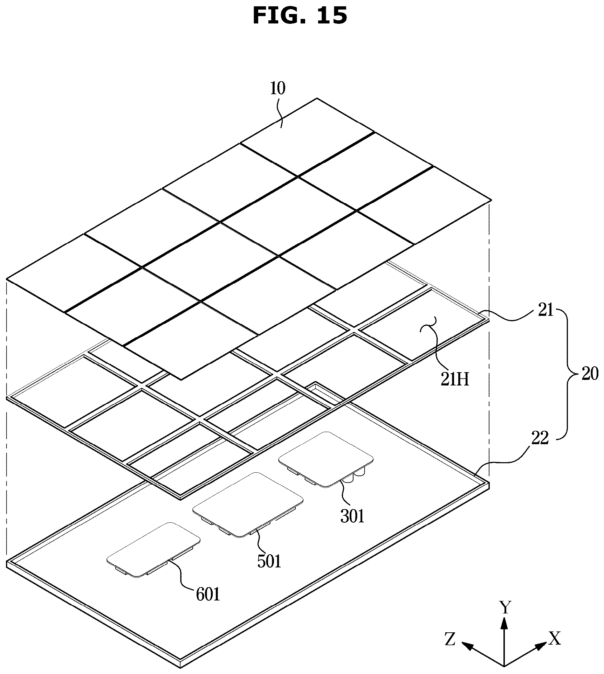

FIG. 15 is a diagram illustrating an example of a method in which a plurality of display modules are coupled to a main body in a display apparatus according to an embodiment.

As described above, the plurality of display modules 10 may be arranged in a 2D matrix form and fixed to the main body 20. Referring to the example of FIG. 15, the plurality of display modules 10 may be installed on a frame 21 located below them, and the frame 21 may have a 2D mesh structure with some regions corresponding to the plurality of display modules 10 being open.

Specifically, as many openings 21H as the number of display modules 10 may be formed at the frame 21, and the openings 21H may have the same arrangement as the plurality of display modules 10.

Each of the plurality of display modules 10 may have bottom edge regions mounted on the frame 21. The bottom edge region may have no circuit elements or wiring formed therein.

The plurality of display modules 10 may be mounted on the frame 21 by using magnetic force from magnets, by being coupled by a mechanical mechanism, or by being adhered with an adhesive. The method by which the display module 10 is mounted on the frame 21 is not limited.

The driving board 501, the main board 301, and the power board 601 may be arranged below the frame 21, and may be electrically connected to each of the plurality of display modules 10 through the openings 21H formed at the frame 21.

A bottom cover 22 may be coupled to the bottom of the frame 21, and the lower cover 22 may form a bottom exterior of the display apparatus 1.

In the foregoing example, the case where the display modules 10 are arranged two-dimensionally has been described, but the display modules 10 may be arranged one-dimensionally, and in this case, the structure of the frame 21 may also be modified into a one-dimensional mesh structure.

In addition, the above-described shape of the frame 21 is merely an example applicable to embodiments of the display apparatus, and the display module 10 may be fixed by applying various shapes of the frame 21.

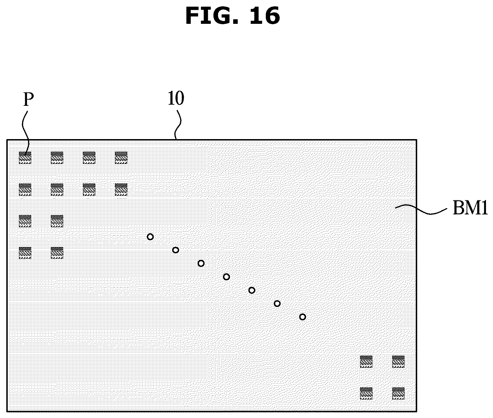

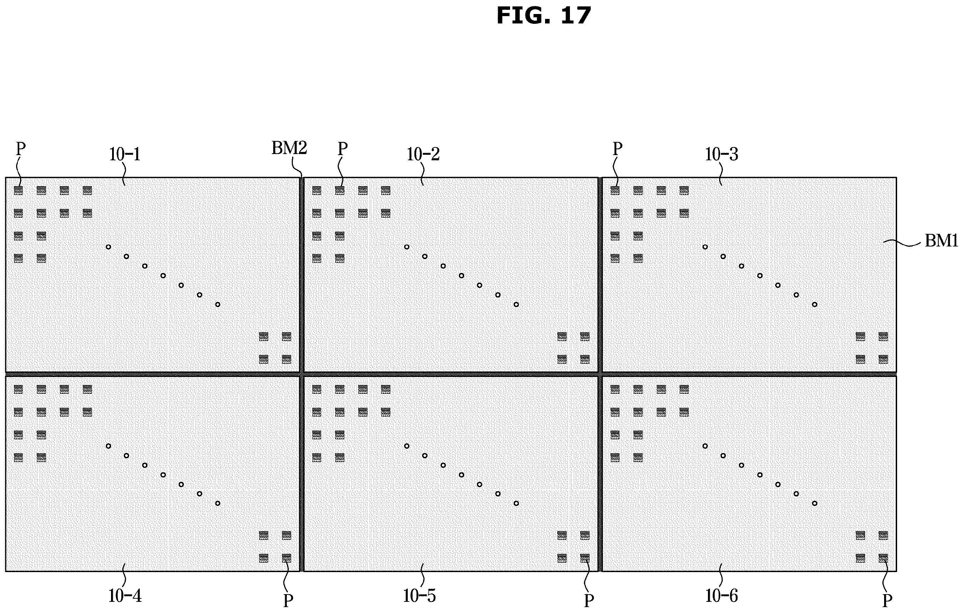

FIG. 16 is a diagram illustrating an example of black matrix (BM) process performed on a display module according to an embodiment, and FIG. 17 is a diagram illustrating an example of BM process performed on a display apparatus according to an embodiment.

Referring to FIG. 16, a BM process may be performed on the display module 10 to block unnecessary light other than light required for image implementation, prevent diffused reflection of light in the gap between pixels, and improve contrast.

For example, a BM layer BM1 may be formed on the substrate 110 by applying one of various BM process methods, such as printing black ink on the substrate 110, patterning with a black photosensitive material, or using a black ACF in mounting the inorganic light emitting device 120 on the substrate 110. In this instance, the BM layer BM1 may also be formed on the upper surface of the micro pixel controller 130 to prevent the micro pixel controller 130 from being visible or diffusely reflecting light.

Referring to FIG. 17, in a case where the plurality of display modules 10 are tiled to implement the display apparatus 1, the BM process may be performed for the spaces between the display modules 10. For example, a side member BM2 of a light-absorbing material may be formed on the side surfaces of each of the plurality of display modules 10-1 to 10-6, especially, side surfaces adjoining the other display module(s) 10, to prevent diffused reflection of light in the space between the modules and gain a seamless effect.

According to an embodiment of the disclosure, a display module may include: a substrate including a glass substrate and at least one layer staked on the glass substrate; a plurality of light emitting devices arranged on the substrate; a plurality of micro pixel controllers arranged on the substrate and configured to drive the plurality of light emitting devices; a power voltage line arranged below the substrate and configured to receive a power voltage from a power board; and a reference voltage line arranged below the substrate and configured to receive a reference voltage from the power board, wherein the glass substrate may include at least one through glass via (TGV) formed in regions other than regions corresponding to the plurality of light emitting devices and the plurality of micro pixel controllers, the power voltage line may be configured to transmit the power voltage to the plurality of micro pixel controllers arranged on the substrate through the at least one TGV, and the reference voltage line may be configured to transmit the reference voltage to the plurality of micro pixel controllers arranged on the substrate through the at least one TGV.

The at least one TGV may include a plurality of TGVs arranged on a single column.

The at least one TGV may include a plurality of TGVs arranged on a single row.

The at least one TGV may include a plurality of TGVs with equal intervals between adjacent TGVs.

The at least one layer may include: a data line configured to transmit a data signal to the plurality of micro pixel controllers; and a gate line configured to transmit a gate signal to the plurality of micro pixel controllers.

The TGV may be formed in regions other than regions corresponding to the data line and the gate line.

The at least one layer may include a thin film transistor (TFT) layer including a plurality of TFTs, and the TGV may be formed in regions other than regions corresponding to the plurality of TFTs.

The at least one layer may include a layer including a gate in panel (GIP) line configured to transmit a gate signal to the plurality of micro pixel controllers, and the TGV may be formed in a region other than a region corresponding to the GIP line.

The display module may further include a buffer layer arranged below the glass substrate, and wherein the buffer layer may include at least one first via hole electrically connected to the at least one TGV.

The display module may further include an insulation layer arranged below the buffer layer, wherein the insulation layer may include at least one second via hole configured to electrically connect the power voltage line or the reference voltage line to the at least one first via hole.

According to an embodiment of the disclosure, a display apparatus may include: a display module including: a substrate including a glass substrate and at least one layer staked on the glass substrate; a plurality of light emitting devices arranged on the substrate; a plurality of micro pixel controllers arranged on the substrate and configured to drive the plurality of light emitting devices; a power voltage line arranged below the substrate and configured to receive a power voltage; and a reference voltage line arranged below the substrate and configured to receive a reference voltage; and a power board configured to supply the power voltage to the power voltage line and supply the reference voltage to the reference voltage line, wherein the glass substrate may include at least one through glass via (TGV) formed in regions other than regions corresponding to the plurality of light emitting devices and the plurality of micro pixel controllers, the power voltage line may be configured to transmit the power voltage to the plurality of micro pixel controllers arranged on the substrate through the at least one TGV, and the reference voltage line may be configured to transmit the reference voltage to the plurality of micro pixel controllers arranged on the substrate through the at least one TGV.

The at least one TGV may include a plurality of TGVs arranged on a single column.

The at least one TGV may include a plurality of TGVs arranged on a single row.

The at least one TGV may include a plurality of TGVs with equal intervals between adjacent TGVs.

The at least one layer may include: a data line configured to transmit a data signal to the plurality of micro pixel controllers; and a gate line configured to transmit a gate signal to the plurality of micro pixel controllers.

The TGV may be formed in regions other than regions corresponding to the data line and the gate line.

The at least one layer may include a thin film transistor (TFT) layer including a plurality of TFTs, and the TGV may be formed in regions other than regions corresponding to the plurality of TFTs.

The at least one layer may include a gate layer including a gate in panel (GIP) line configured to transmit a gate signal to the plurality of micro pixel controllers, and the TGV may be formed in a region other than a region corresponding to the GIP line.

The display module may further include a buffer layer arranged below the glass substrate, and wherein the buffer layer may include at least one first via hole electrically connected to the at least one TGV.

The display module may further include an insulation layer arranged below the buffer layer.

The insulation layer may include at least one second via hole configured to electrically connect the power voltage line or the reference voltage line to the at least one first via hole.

Meanwhile, the disclosed embodiments may be implemented in the form of a recording medium that stores instructions executable by a computer. The instructions may be stored in the form of program codes, and when executed by a processor, the instructions may generate a program module to perform the operations of the disclosed embodiments. The recording medium may be implemented as a computer-readable recording medium.

The computer-readable recording medium may include all kinds of recording media storing instructions that can be interpreted by a computer. For example, the computer-readable recording medium may be read only memory (ROM), random access memory (RAM), a magnetic tape, a magnetic disc, a flash memory, an optical data storage device, etc.

The computer-readable storage medium may be provided in the form of a non-transitory storage medium. Here, when a storage medium is referred to as "non-transitory", it may be understood that the storage medium is tangible and does not include a signal (e.g., an electromagnetic wave), but rather that data is semi-permanently or temporarily stored in the storage medium. For example, a "non-transitory storage medium" may include a buffer in which data is temporarily stored.

The method according to various embodiments disclosed herein may be provided in a computer program product. The computer program product may be traded between a seller and a buyer as a product. The computer program product may be distributed in the form of a machine-readable storage medium (e.g., compact disc read only memory (CD-ROM)), or may be distributed (e.g., download or upload) through an application store (e.g., Play Store^{™}) online or directly between two user devices (e.g., smartphones). In the case of online distribution, at least a portion of the computer program product (e.g., downloadable app) may be stored at least semi-permanently or may be temporarily generated in a storage medium, such as a memory of a server of a manufacturer, a server of an application store, or a relay server.

Although embodiments of the disclosure have been described with reference to the accompanying drawings, a person having ordinary skilled in the art will appreciate that other specific modifications may be easily made without departing from the technical spirit or essential features of the disclosure. Therefore, the foregoing embodiments should be regarded as illustrative rather than limiting in all aspects.

## Claims

1. A display module, comprising:
a substrate comprising a glass substrate and at least one layer staked on the glass substrate;
a plurality of light emitting devices arranged on the substrate;
a plurality of micro pixel controllers arranged on the substrate and configured to drive the plurality of light emitting devices;
a power voltage line arranged below the substrate and configured to receive a power voltage from a power board; and
a reference voltage line arranged below the substrate and configured to receive a reference voltage from the power board,
wherein the glass substrate comprises at least one through glass via (TGV) formed in regions other than regions corresponding to the plurality of light emitting devices and the plurality of micro pixel controllers,
the power voltage line is configured to transmit the power voltage to the plurality of micro pixel controllers arranged on the substrate through the at least one TGV, and
the reference voltage line is configured to transmit the reference voltage to the plurality of micro pixel controllers arranged on the substrate through the at least one TGV.

2. The display module of claim 1, wherein the at least one TGV comprises a plurality of TGVs arranged on a single column.

3. The display module of claim 1, wherein the at least one TGV comprises a plurality of TGVs arranged on a single row.

4. The display module of claim 1, wherein the at least one TGV comprises a plurality of TGVs with equal intervals between adjacent TGVs.

5. The display module of claim 1, wherein the at least one layer comprises:
a data line configured to transmit a data signal to the plurality of micro pixel controllers; and
a gate line configured to transmit a gate signal to the plurality of micro pixel controllers.

6. The display module of claim 5, wherein the TGV is formed in regions other than regions corresponding to the data line and the gate line.

7. The display module of claim 1, wherein the at least one layer comprises a thin film transistor (TFT) layer including a plurality of TFTs, and
the TGV is formed in regions other than regions corresponding to the plurality of TFTs.

8. The display module of claim 1, wherein the at least one layer comprises a layer including a gate in panel (GIP) line configured to transmit a gate signal to the plurality of micro pixel controllers, and
the TGV is formed in a region other than a region corresponding to the GIP line.

9. The display module of claim 1, further comprising:
a buffer layer arranged below the glass substrate,
wherein the buffer layer comprises at least one first via hole electrically connected to the at least one TGV.

10. The display module of claim 9, further comprising:
an insulation layer arranged below the buffer layer,
wherein the insulation layer comprises at least one second via hole configured to electrically connect the power voltage line or the reference voltage line to the at least one first via hole.

11. A display apparatus, comprising:
a display module comprising:
a substrate comprising a glass substrate and at least one layer staked on the glass substrate;
a plurality of light emitting devices arranged on the substrate;
a plurality of micro pixel controllers arranged on the substrate and configured to drive the plurality of light emitting devices;
a power voltage line arranged below the substrate and configured to receive a power voltage; and
a reference voltage line arranged below the substrate and configured to receive a reference voltage; and
a power board configured to supply the power voltage to the power voltage line and supply the reference voltage to the reference voltage line,
wherein the glass substrate comprises at least one through glass via (TGV) formed in regions other than regions corresponding to the plurality of light emitting devices and the plurality of micro pixel controllers,
the power voltage line is configured to transmit the power voltage to the plurality of micro pixel controllers arranged on the substrate through the at least one TGV, and
the reference voltage line is configured to transmit the reference voltage to the plurality of micro pixel controllers arranged on the substrate through the at least one TGV.

12. The display apparatus of claim 11, wherein the at least one TGV comprises a plurality of TGVs arranged on a single column.

13. The display apparatus of claim 11, wherein the at least one TGV comprises a plurality of TGVs arranged on a single row.

14. The display apparatus of claim 11, wherein the at least one TGV comprises a plurality of TGVs with equal intervals between adjacent TGVs.

15. The display apparatus of claim 11, wherein the at least one layer comprises:
a data line configured to transmit a data signal to the plurality of micro pixel controllers; and
a gate line configured to transmit a gate signal to the plurality of micro pixel controllers.
